# EUROPEAN PATENT APPLICATION

(11) **EP 2 568 795 A1**
(43) Date of publication of application: **13.03.2013**
(21) Application number: 12425146.3
(22) Date of filing: 05.09.2012
(51) Int. Cl.: H05K 7/20

(54) **Cabinet for the allocation of transmission lines of voice and data, provided with a geothermal air conditioning system**

(30) Priority: 07.09.2011 IT RM20110464
(71) Applicant: C.I.S. Sud s.r.l., 00040 Ariccia (RM) (IT)
(72) Inventor: Spinelli, Carlo, 00040 Ariccia (RM) (IT); Fortini, Carlo, 00040 Ariccia (RM) (IT); Malpezzi, Ettore, 00040 Ariccia (RM) (IT)
(74) Representative: Santi, Filippo

(57) **Abstract**

The present invention relates to a cabinet (10) for allocation of transmission lines of voice and data, equipped with a temperature conditioning system of geothermal type, comprising a hydraulic circuit, inside which flows a heat transfer fluid and which includes, inside said cabinet (10), a heat exchanger (11), a pump (12), disposed upstream of said heat exchanger (11), in the sense of circulation of said heat transfer fluid, and a unidirectional valve (13), disposed downstream of said heat exchanger (11), in the sense of circulation of said heat transfer fluid, and, externally to said cabinet (10), a geothermal probe, connected to the rest of the circuit through a delivery conduit (14, 14 ') and a return conduit (14, 14").

## Description

The present invention relates to a cabinet for the allocation of transmission lines of voice and data provided with a geothermal air conditioning system.

The invention relates to the field of telecommunications and more particularly to the field of infrastructure for the transmission of acoustic signals and data, commonly indicated with the name of the telephone network.

It is known that the copper telephone network is essentially constituted firstly by copper cables of big potential, large number of pairs or of lines, which depart from the telephone exchange, and secondly by copper cables of small potential, which reach the utility customers. The cables of big potential constitute the so-called primary network, while the cables of small potential constitute the secondary network. The essential element connecting these cables to each other and enable the distribution of pairs or lines is the so-called street (LD line distribution) cabinet. A cable of the primary network leale from the telephone exchange and arrives to the cabinet, from which depart the same lines, on multiple cables, of the secondary network, which reaches the various buildings of residence of users. The LD cabinet is generally located at a distance of some kilometers from the telephone exchange, while it is a few hundred meters from the users.

In recent times, the copper network proved to be suitable not only for transmitting audio, but also for the use of modern digital technologies for high-capacity data transmissions, like: DSL, ADSL, VDSL. The transmission speed or bandwidth with which data can be transmitted on the copper network depends on the physical length of the same. If the distance of the user from the apparatus located in the telephone exchange is several kilometers, the possible bandwidth is of the order of 2-4 Mbps, while if the distance is some hundred meters the bandwidth is of the order of 10-20 Mbit.

On the other hand, a current trend for reducing the costs of management consists in the elimination of peripheral telephone exchanges. Furthermore, the current transmission technique allows the realization of more and more compact equipment.

From the above, it appears increasingly convenient the possibility of transferring the equipment in (DL) cabinets, replacing the copper cables of the primary network with fiber optic cables (broadband physical carrier) and using copper cables only for the secondary network.

However, putting the electronic devices in DL cabinets involves some major technical problems.

In fact, the electronic devices are active elements, which dissipate energy, and that work correctly in a limited range of temperatures, normally between - 5 °C and + 60 °C. Therefore, to ensure their proper functioning, conditioning the temperature of DL cabinets becomes indispensable.

The temperature conditioning becomes very important especially in summer, but the same problem recurs even in winter, although to a lesser extent.

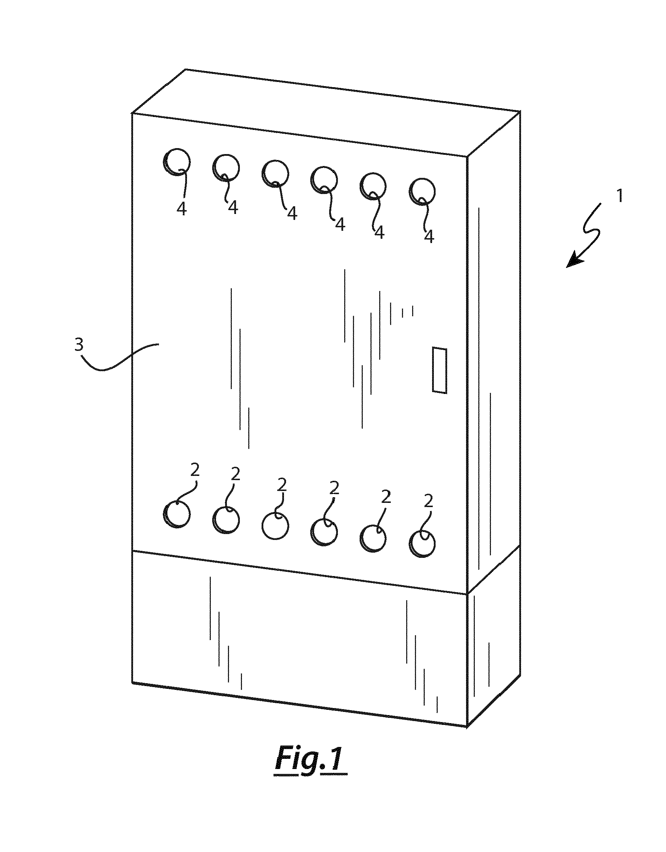

To solve the problem of overheating in summer use was made of DL cabinets with air conditioning and forced air circulation through the use of several fans. Figure 1 shows an air-conditioned DL cabinet (indicated by the reference number 1) realised according to this type of solution of the prior art and equipped with a battery of six fans, accessible through the same number of openings 2 arranged on a horizontal line positioned in the bottom of a door 3 of the LD cabinet 1, drawing air from the outside and another battery of six fans, accessible through the same nunber of openings 4 arranged on a horizontal line at the top, which drive the air from the inside to the outside of the LD cabinet 1.

This type of solution involves many disadvantages, such as:
- the cost of power for tens of kW/h per day;
- specific maintenance costs for all the moving mechanical parts;
- the cost of maintenance and cleaning of mechanical filters, used in order to avoid the fall-out of the external environment, polluting the internal one, where the equipment, which is particularly sensitive, is located;
- the so-called social costs, such as environmental pollution, the mechanical noise of the fans, the invasive maintenance interventions involving urban traffic congestion.

In winter, on the other hand, it is possible to intervene more simply using electrical resistors, which condition the internal environment of the LD cabinets, having as a negative aspect the increased cost of system power supplying.

All these negative aspects, descrive above, have made it difficult the use of LD cabinets according to this solution, in many cases leading operators not to use this kind of cabinets and renouncing to the advantages, in terms of bandwidth, to provide to the users.

In this context it is included the solution according to the present invention, which aims at eliminating all the drawbacks described above, making also further positive aspects, through the passive dissipation of heat, in summer, or the passive acquisition of heat, in winter, realized with a heat exchange that uses geothermal energy of the ground in the area where the LD cabinet is located.

These and other results are obtained according to the present invention by proposing a cabinet for the allocation of transmission lines of voice and data provided with a geothermal air conditioning system.

The purpose of the present invention is therefore to provide a cabinet of allocation of lines equipped with an air conditioning system that allows to overcome the limits of the LD cabinets conditioned according to the known technology and to obtain the technical results previously described.

Further object of the invention is that said cabinet of allocation of lines can be manufactured with substantially limited costs, both as regards production costs and as regards the management costs.

Another object of the invention is to propose a cabinet of allocation of lines equipped with an air conditioning system of geothermal type which is simple, safe and reliable.

It is therefore specific object of the present invention a cabinet of allocation of transmission lines of voice and data, equipped with a temperature conditioning system of geothermal type, comprising a hydraulic circuit, inside which a heat transfer fluid flows and which includes, inside said cabinet, a heat exchanger, a pump, arranged upstream of said heat exchanger, in the sense of circulation of said heat transfer fluid, and a check valve, disposed downstream of said heat exchanger, in the sense of circulation of said heat transfer fluid; and, outside of said cabinet, a geothermal probe, connected to the rest of the circuit through a delivery conduit and a return conduit.

In particular, according to the invention, said heat exchanger is an air-water heat exchanger.

Preferably, according to the present invention, said delivery conduit includes a flexible hose, more preferably made of cross-linked high density polyethylene, as well as said return conduit comprises a flexible hose, more preferably of cross-linked high density polyethylene.

Furthermore, always according to the invention, said probe is selected from a geothermal horizontal probe, a vertical probe and a volumetric probe.

The present invention will be now described, for illustrative but not limitative purposes, according to its preferred embodiment, with particular reference to the figures of the accompanying drawings, in which:
- Figure 1 shows a perspective view of an air-conditioned LD cabinet according to the prior art,
- Figure 2 shows a graph of the variation of temperature at different depths in the subsoil of Catania on the day of July 21, 2011,
- Figure 3 shows a graph of the variation of the temperature at different depths in the subsoil of Bolzano in the day of January 21, 2011,
- Figure 4 shows a schematic view of a system for temperature conditioning of the inside of a LD cabinet according to the present invention,
- Figure 5a shows a schematic view of a horizontal geothermal probe usable with the conditioning system of figure 4,
- Figure 5b shows a schematic view of the horizontal geothermal probe of Figure 5a, from a viewpoint orthogonal to that of Figure 5a,
- Figure 6 shows a schematic view of a vertical geothermal probe usable with the conditioning system of figure 4, and
- Figure 7 shows a schematic view of a volumetric geothermal probe usable with the air conditioning system of Figure 4.

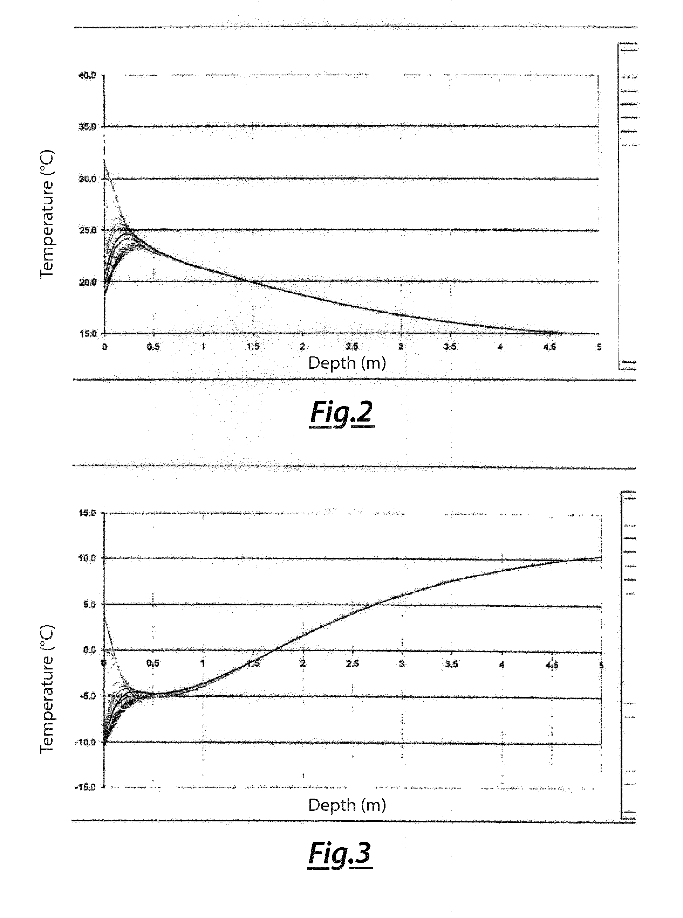

By preliminarily making reference to Figures 2 and 3, it is shown how the temperature of the soil, starting from the ground level, is always less variable with the depth, until becoming constant when reaching a characteristic depth, which depends on the constitutional nature of the soil itself.

In particular, Figure 2 is a graph of the variation of the temperature of the subsoil of Catania in the day of 21 July 2011. It is shown that, in this land of sandy nature, at about 5 meters of depth the temperature becomes constant, no more undergoing the changes of the temperature of the environmental area.

Figure 3 shows a graph of the variation of the temperature of the subsoil of sandy nature in Bolzano on the day of January 21, 2011. Even in this case, about 5 meters deep it is possible to find a temperature that becomes equally constant.

Therefore, it can be assumed with good approximation that the ground, at a given depth, remains at a constant temperature throughout the year.

This natural feature can be exploited to condition the temperature of a heat transfer fluid (water and ethylene glycol) of an temperature conditioning system realized within a LD cabinet.

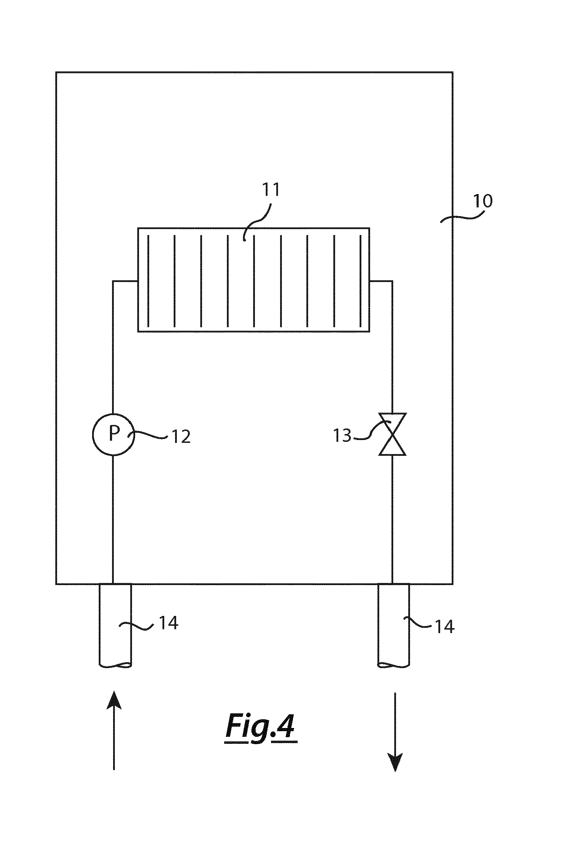

In this respect, Figure 4 shows a system of temperature conditioning of the inside of a LD cabinet realized according to the present invention, ie realized for the connection with external geothermal probes (not shown in figure 4, but that will be illustrated in the following figures) for the exchange of heat with the ground. In particular, inside the LD cabinet, indicated with the reference number 10, Figure 4 shows an air-water exchanger 11, a pump 12 (which for example may be a 10 W pump) for the forced circulation of the fluid and a one-way valve 13 for controlling the flow of the same. The circuit of the system is constituted by a tube and preferably by a flexible hose 14 (which for example can be made of polyethylene with high density of cross linking which ensures high homogeneity of the heat exchange characteristics and long time operating life).

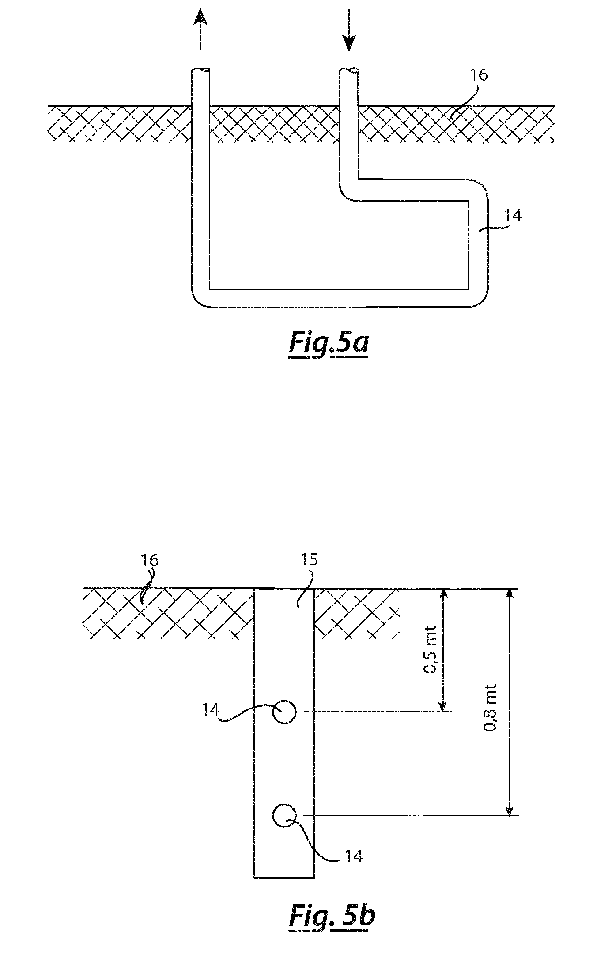

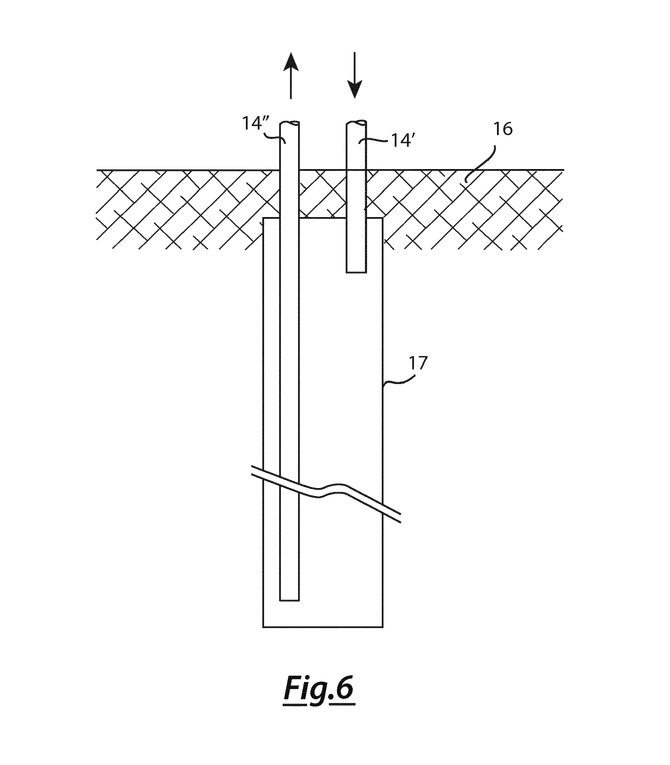

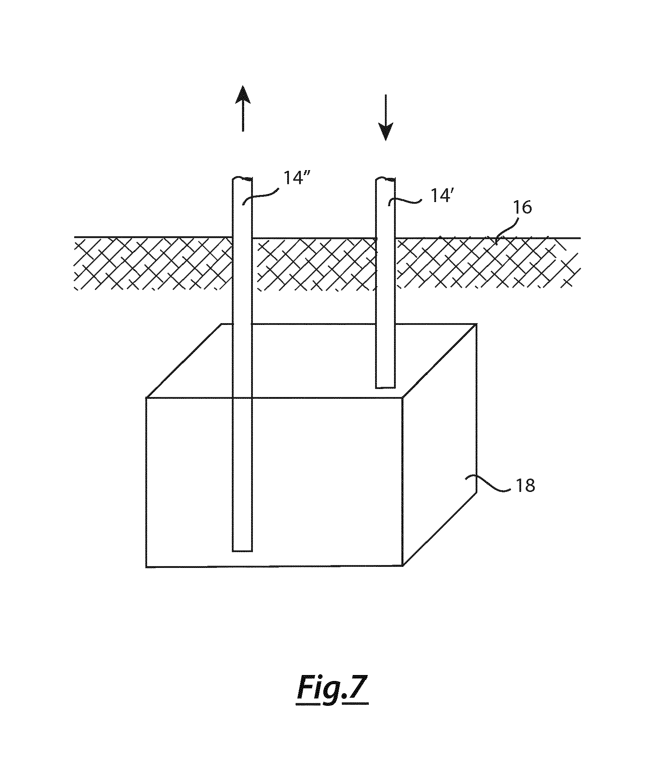

Figures 5a, 5b, 6 and 7 show different types of geothermal probes for use with the system of temperature conditioning according to the present invention and in particular Figures 5a and 5b show a horizontal geothermal probe, Figure 6 shows a vertical geothermal probe and Figure 7 shows a volumetric geothermal probe.

With reference to Figures 5a and 5b, a horizontal geothermal probe is made, in the circuit round trip, with one and the same flexible tube 14 in continuity, laid in the trench 15 at two different depths and for a length of excavation defined according to the nature of the ground 16.

With reference to Figure 6, a vertical geothermal probe is made by placing a shell 17 (which for example can be made of steel) in depth for a length defined according to the nature of the ground 15. At the deep end the shell 17 is closed and is filled with the heat transfer fluid. The tube 14' of the delivery circuit ends inside the head of the shell 17, while the return tube 14" leaves from the internal deep base of the shell 17.

With reference to Figure 7, a volumetric geothermal probe consists of a tank 18 (which for example can have a parallelepiped shape and be made of steel), laid at a depth defined by the nature of the ground 16. The tank 18 is filled with a heat transfer fluid. The tube 14' of the delivery circuit ends on the upper inner of the tank 18, while the return tube 14" leaves from the lower inner part of the same tank 18.

In particular, the vertical and volumetric probes can be realized with great capacity of heat transfer fluid. This results in a high thermal inertia of the geothermal system. The thermal inertia is particularly important in conditioning of all peak temperatures which often occur in the exercise of the LD cabinets.

With the use of the cabinet for the allocation of transmission lines of voice and data provided with a geothermal air conditioning system according to the present invention there is also the advantage of reducing the encumbrance of the total volume of the LD cabinets of 10%, with the same space for equipment, with respect to the LD cabinets provided with a system of fans. This is possible due to the fact that free spaces for large flows of air of the fan are no longer required.

Another important advantage is that the cabinet of metal shields all electrical noise from inside or outside of it, being completely sealed during operation.

A particularly important feature in the cabinet for the allocation of transmission lines of voice and data provided with a geothermal air conditioning system according to the present invention is the sizing of the geothermal probe, which must be such as to ensure the maintenance of a cabinet internal temperature, subject to adjustment between - 5 °C and + 60 °C.

According to the present invention in particular two types of LD cabinet have been identified, having different sizes, one of the type commonly called in the field large (size of the base 1600mm x 400mm, height 1900mm) and one of the type commonly called small (750x316mm, 1520mm). However, the considerations given below for these two cases are also valid for the LD cabinets of different volume sizes.

The LD cabinet of the large type dissipates internal energy of the apparatuses of 1500 W, with peaks of heat of 2000 W for a daily total of about 15 kW/h. For this dissipation a vertical geothermal probe was designed (of the type already shown with reference to Figure 6), formed by a shell 17 of steel with a diameter of 200 mm, driven into the ground to a depth equal to 12 meters, with a total volume of heat transfer fluid of about 380 liters.

The small LD cabinet dissipates internal energy of the equipment of 600 W with heat peaks of 1000 W for a daily total of about 7,5 kW/h. For this dissipation, a volumetric geothermal probe was designed, consisting of a parallelepiped tank 18 of steel, buried at a depth from the surface level H = 40 cm, with a total volume of heat transfer fluid of about 450 liters.

The present invention has been described for illustrative but not limitative purposes, according to its preferred embodiments, but it is to be understood that variations and/or modifications can be made by those skilled in the art without departing from the relevant scope of protection , as defined by the appended claims.

## Claims

1. Cabinet (10) for the allocation of lines of transmission of voice and data, **characterized in that** it is equipped with a temperature conditioning system of geothermal type, comprising a hydraulic circuit, inside which a heat transfer fluid flows and which includes, inside said cabinet (10), a heat exchanger (11), a pump (12), arranged upstream of said heat exchanger (11), in the sense of circulation of said heat transfer fluid, and a check valve (13), arranged downstream of said heat exchanger (11), in the sense of circulation of said heat transfer fluid, and, externally to said cabinet (10), a geothermal probe, connected to the rest of the circuit through an delivery conduit (14, 14 ') and a return conduit (14, 14").

2. Cabinet (10) of allocation of lines according to claim 1, **characterized in that** said heat exchanger (11) is an air-water heat exchanger (11).

3. Cabinet (10) of allocation of lines according to claim 1 or 2, **characterized in that** said delivery conduit (14, 14') comprises a flexible hose (14, 14').

4. Cabinet (10) of allocation of lines according to any one of the preceding claims, **characterized in that** said delivery conduit (14, 14') comprises a flexible hose (14, 14') made of cross linked high density polyethylene.

5. Cabinet (10) of allocation of lines according to any one of the preceding claims, **characterized in that** said return conduit (14, 14") comprises a flexible hose (14, 14").

6. Cabinet (10) of allocation of lines according to any one of the preceding claims, **characterized in that** said return conduit (14, 14") comprises a flexible hose (14, 14") of cross linked high density polyethylene.

7. Cabinet (10) of allocation of lines according to any one of the preceding claims, **characterized in that** said probe is selected from a geothermal horizontal probe, a vertical probe and a volumetric probe.
